# EUROPÄISCHE PATENTSCHRIFT

(11) **EP 1 893 008 B1**
(45) Veröffentlichungstag und Bekanntmachung des Hinweises auf die Patenterteilung: **24.11.2010**
(21) Anmeldenummer: 07013535.5
(22) Anmeldetag: 11.07.2007
(51) Int. Cl.: H05K 5/03, H05K 7/14

(54) **Leadframemagazin-Magazindeckel und Leadframemagazin mit einem solchen Magazindeckel**
Magazine cover for a leadframe magazine and leadframe magazine with such a magazine cover
Couvercle de magasin pour magasin de cadres de connection et magasin de cadres de connection muni d'un tel couvercle

(30) Priorität: 21.08.2006 DE 102006038997
(43) Veröffentlichungstag der Anmeldung: 27.02.2008
(73) Patentinhaber: Micronas GmbH, 79108 Freiburg (DE)
(72) Erfinder: Güntert, Jürgen, 83278 Taunstein (DE); Schuhler, Bernard, 68240 Sigolsheim (FR)
(74) Vertreter: Koch Müller Patentanwaltsgesellschaft mbH

(56) Entgegenhaltungen:
- DE-U1- 29 500 447
- GB-A- 2 138 213
- JP-A- 6 122 487
- JP-A- 6 171 684
- JP-A- 11 115 984

## Beschreibung

Die Erfindung bezieht sich auf einen Leadframemagazin-Magazindeckel zum Verschließen von Leadframemagazinen. Insbesondere bezieht sich die Erfindung auf das Verschließen einer Öffnung eines Leadframemagazines, bei dem der Magazindeckel in das Leadframemagazin eingeschoben wird.

Bei Leadframemagazinen handelt es sich um Transport- und Lagerbehältnisse für so genannte Leadframes. Die bestückten Leadframes werden durch eine Öffnung in das Leadframemagazin geführt und z.B. auf Auflagen abgelegt oder in Schienenführungen gehalten. Der Magazindeckel verhindert ein Herausrutschen der Leadframes. Der Magazindeckel wird in Führungsschienen geführt, welche in seitlichen Wandungen des Leadframemagazin ausgebildet sind. Ein solcher Leadframemagazin ist aus JP-A-06171684 bekannt. Bei Leadframes handelt es sich insbesondere um mit Stukturelementen bestückte Kupferfolien. Bei den Strukturelementen handelt es sich um Computerchips und andere elektronische Bauteile. Die Bauteile werden mit kleinen Drähten, so genannten Bonddrähten mit Leiterbahnen oder Abschnitten der Kupferfolien, welche später als solche auszubilden sind, verlötet oder verschweißt.

Nachteilhaft ist, wenn die Leadframes nicht ganz in das Leadframemagazin eingeschoben oder wieder herausgerutscht sind. Wenn der Magazindeckel in der Schließrichtung zugeschoben wird, kann es dann durch die in Schließrichtung vordere Kante des Magazindeckels zu einer Beschädigung von Bonddrähten oder sonstigen Komponenten auf dem Leadframe kommen. Insbesondere kann es bei dem Verschließen zu kaum sichtbaren Beschädigungen kommen. Solche Beschädigungen können die spätere Funktion der Leadframes oder von deren Elementen führen.

Die Aufgabe der Erfindung besteht darin, einen Magazindeckel so bereitzustellen, dass ein entsprechendes Beschädigungsrisiko der Leadframes ausgeschlossen oder reduziert werden kann.

Diese Aufgabe wird durch einen Magazindeckel mit den Merkmalen gemäß Patentanspruch 1 gelöst. Vorteilhafte Ausgestaltungen sind Gegenstand abhängiger Ansprüche.

Es wird ein Leadframemagazin-Magazindeckel vorgelegt, zum Verschließen einer Öffnung eines Leadframemagazines durch Einschieben des Magazindeckels in das Leadframemagazin in einer Schließrichtung, wobei im Bereich eines Deckelrands des Magazindeckels in Schließrichtung des Magazindeckels eine Ausnehmung ausgebildet ist. Durch eine solche Ausnehmung wird verhindert, dass Strukturelemente auf einem noch aus dem Leadframemagazin herausragenden Leadframe beim Schließen des Leadframemagazines beschädigt werden.

Bevorzugt ist die Ausnehmung in Schließrichtung in einem Bereich von zumindest einem Strukturelement auf einer Oberfläche eines in dem Leadframemagazin aufnehmbaren Leadframes gegenüberliegend ausgebildet. Dadurch kommt der Deckel nur auf einem unbestückten Bereich des Leadframes zum Liegen.

Eine Ausnehmungshöhe der Ausnehmung ist vorteilhaft vom Deckelrand aus größer als eine Strukturelementhöhe des Strukturelements. Dadurch kann beim Einschieben des Magazindeckels dessen Vorderkante in Einschubrichtung nicht mit Strukturelementen auf einem aus dem Magazin herausragenden Leadframe zusammenstoßen. Beschädigungen solcher Strukturelemente mit einer Höhe geringer als der Ausnehmungshöhe werden entsprechend vermieden. Das zumindest eine Strukturelement ist insbesondere ein Bonddraht.

Eine Wandung des Magazindeckels kann ausgebildet sein zum Vergrößern der Ausnehmung je nach den Bedürfnissen der Leadframes. Diese kann z.B. durch Sollbruchstellen ermöglicht werden, welche ein Herausbrechen von Wandabschnitten ermöglichen. Dadurch können auch nachträglich Ausnehmungen bzw. Aussparungen in einen solchen Deckel eingearbeitet werden.

Die Ausnehmung ist in seitlicher Richtung quer zur Schließrichtung bevorzugt durch zumindest einen in Schließrichtung vorstehenden Wandungsabschnitt des Leadframemagazin-Magazindeckels begrenzt.

Der vorstehende Wandungsabschnitt ist in Schließrichtung einem Leadframe gegenüberliegend in einem Bereich des Leadframes ausgebildet, wobei in dem Bereich keine oder nur durch Zusammenstoß nicht beschädigbare Strukturelemente auf einer Oberfläche des in dem Leadframemagazin aufnehmbaren Leadframes ausgebildet sind. Dadurch kommt der Deckel nur auf einem insbesondere unbestückten Bereich des Leadframes zu Liegen.

Der Magazindeckel ist vorzugsweise mittels eines Spritzgussverfahrens aus Kunststoff herstellbar. Dadurch kann ein geeigneter Magazindeckel direkt bei seiner Herstellung mit einer geeigneten Ausnehmung hergestellt werden. Besonders bevorzugt werden jedoch aus einem metallischen oder elektrisch leitfähigen Material ausgebildet, da diese eine elektromagnetische Abschirmung von im Leadframemagazin aufgenommenen Leadframes ermöglichen.

Ein Ausführungsbeispiel wird nachfolgend anhand der Zeichnungen näher erläutert. Es zeigen:
- Fig. 1: einen Ausschnitt eines Leadframemagazins mit teilweise herausragendem Leadframe und mit teilweise geschlossenem Leadframemagazin-Magazindeckel und
- Fig. 2: eine Seitenansicht zu der Ausführungsform gemäß Fig. 1.

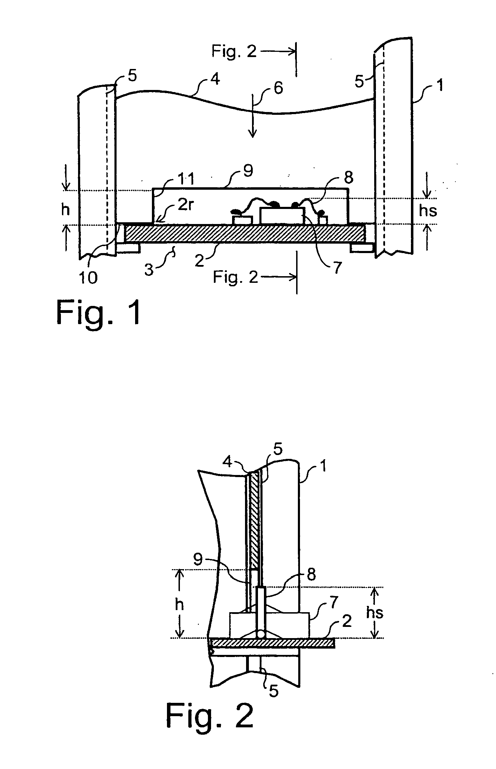

In Fig. 1 und 2 ist beispielhaft ein Leadframemagazin 1 zum Aufnehmen von so genannten Leadframes 2 dargestellt. Zum Einsetzen solcher schematisch dargestellter Leadframes 2 weist das Leadframemagazin 1 eine Öffnung 3 auf, welche durch einen Leadframemagazin-Magazindeckel 4 verschließbar ist.

Zum Verschließen der Öffnung 3 mittels des Leadframemagazin-Magazindeckels 4 weist das Leadframemagazin 1 Führungsschienen 5, z.B. Nuten in dessen Seitenwandungen auf. Das Verschließen erfolgt entsprechend durch Einschieben des Leadframemagazin-Magazindeckels 4 in die Führungsschienen 5 in einer Schließrichtung 6.

Im Fall eines in den Bereich der Öffnung 3 ragenden oder eines aus der Öffnung 3 herausragenden Leadframes 2 können beim Schließen auf diesem angeordnete Strukturelemente, insbesondere ein Chip 7 oder ein empfindlicher Bonddraht 8, beschädigt werden. Um dies zu vermeiden, weist der Leadframemagazin-Magazindeckel 4 in seinem in Schließrichtung 6 vorderseitigen Abschnitt eine Ausnehmung 9 auf. Die Ausnehmung 9 führt von einer in Schließrichtung 6 liegenden Vorderkante 10 des Leadframemagazin-Magazindeckels 4 in den Leadframemagazin-Magazindeckel 4 hinein.

Die Ausnehmung 9 ist so angeordnet und dimensioniert, dass die Strukturelemente wie die Bonddrähte 8 oder andere Bauteile von der Vorderkante 10 des Magazindeckels 4 in dessen Schließrichtung 6 nicht berührt werden. Der Magazindeckel 4 berührt den Leadframe 2 an einer oder mehreren Bereichen 2r der Oberfläche des Leadframes 2, an denen keine beschädigbaren Strukturelemente wie Bauteile und Bonddrähte angeordnet sind. Dadurch wird eine Beschädigung von empfindlichen Strukturelementen ausgeschlossen.

Vorzugsweise erstreckt sich die Ausnehmung 9 von der Vorderkante 10 aus derart um die Ausnehmungshöhe h in den Leadframemagazin-Magazindeckel 4, dass die Ausnehmungshöhe h gleich oder größer einer Strukturelementhöhe hs der Strukturelemente ist. Die Ausnehmungshöhe h ist so gewählt, dass vorzugsweise ein Sicherheitsabstand vorhanden ist, welcher Bauteiltoleranzen der Strukturelemente berücksichtigt. Vorzugsweise ist auch eine Ausnehmungsbreite quer zur Schließrichtung 6 den Bedürfnissen der in dem Leadframemagazin 1 aufzunehmenden Leadframes 2 angepasst.

Vorzugsweise ist die Ausnehmung 9 etwa mittig in dem Magazindeckel 4 ausgebildet. Je nach der Bestückung der Leadframes 2 mit den Strukturelementen kann auch eine andere Lage der Ausnehmung 9 vorgesehen sein. Auch können mehrere solche Ausnehmung 9 im Magazindeckel 4 ausgebildet sein. Insbesondere können auch eine oder mehrere Ausnehmungen von z.B. einem in Schließrichtung 6 vorderseitig stegartig ausgebildeten Vorsprung bis zum seitlichen Rand des Magazindeckels 4 quer zur Schließrichtung 6 ausgebildet sein.

Durch die Herstellung mittels eines Spritzgussverfahrens ist ein solcher Magazindeckel 4 mit der Ausnehmung in einem Arbeitsschritt herstellbar. Jedoch kann die Ausnehmung auch nachträglich ausgebildet oder vergrößert werden, insbesondere im Fall bei Herstellung aus einem metallischen oder mit Metall beschichteten Material.

Eine Wandung des Magazindeckels 4 kann optional ausgebildet sein zum nachträglichen Ausbilden oder Vergrößern der Ausnehmung 9 je nach den Bedürfnissen einzulagernder Leadframes 2. Für ein nachträgliches Vergrößern der Ausnehmung 9 können z.B. Sollbruchstellen in der Wandung des Magazindeckels 4 vorgesehen sein.

## Patentansprüche

1. Leadframemagazin-Magazindeckel zum Verschließen einer Öffnung eines Leadframemagazines durch Einschieben des Magazindeckels (4) in das Leadframemagazin (1) in einer Schließrichtung (6),
**dadurch gekennzeichnet, dass**
im Bereich einer Vorderkante (10) des Magazindeckels (4) in Schließrichtung (6) des Magazindeckels (4) eine Ausnehmung (9) ausgebildet ist.

2. Leadframemagazin-Magazindeckel nach Anspruch 1, bei dem die Ausnehmung (9) in Schließrichtung (6) in einem Bereich eines durch den Magazindeckel (4) beschädigbares Strukturelement auf einer Oberfläche eines in dem Leadframemagazin (1) aufnehmbaren Leadframes (2) gegenüberliegend ausgebildet ist.

3. Magazindeckel nach Anspruch 2, bei dem eine Ausnehmungshöhe (h) der Ausnehmung von der Vorderkante (10) aus größer als eine Strukturelementhöhe (hs) des Strukturelements ist.

4. Magazindeckel nach Anspruch 2 oder 3, bei dem das zumindest eine Strukturelement ein Bonddraht (8) ist.

5. Magazindeckel nach einem vorstehenden Anspruch, dessen Wandung ausgebildet ist zum Vergrößern der Ausnehmung (9) je nach den Ausgestaltungen eines einzusetzenden Leadframes (2).

6. Magazindeckel nach einem vorstehenden Anspruch, bei dem die Ausnehmung (9) in seitlicher Richtung quer zur Schließrichtung (6) durch zumindest einen in Schließrichtung vorstehenden Wandungsabschnitt (11) des Magazindeckels (4) begrenzt ist.

7. Leadframemagazin-Magazindeckel nach Anspruch 6, bei dem der Wandungsabschnitt (11) in Schließrichtung (6) einem Bereich des in dem Leadframemagazin (1) aufnehmbaren Leadframes (2) gegenüberliegend angeordnet ist, wobei in dem Bereich keine oder keine durch Zusammenstoß mit dem Magazindeckel (4) beschädigbare Strukturelemente auf einer Oberfläche des Leadframes (2) ausgebildet sind.

8. Leadframemagazin-Magazindeckel nach einem vorstehenden Anspruch, der mittels eines Spritzgussverfahrens hergestellt ist.

9. Leadframemagazin mit einem Leadframemagazin-Magazindeckel (2) nach einem vorstehenden Anspruch.

## Claims

1. Magazine cover of a lead-frame magazine for the closing and opening of a lead-frame magazine by insertion of the magazine cover (4) into the lead-frame magazine (1) in a closing direction (6), **characterised in that** a recess (9) is formed in the region of the front edge (10) of the magazine cover (4) in closing direction (6) of the magazine cover (4).

2. Magazine cover of a lead-frame magazine according to claim 1, in which the recess (9) is formed in closing direction (6) to be opposite in a region of a structure element, which can be damaged by the magazine cover (4), on a surface of a lead frame receivable in the lead-frame magazine (1).

3. Magazine cover according to claim 2, in which a recess height (h) of the recess is greater, from the front edge (10), than a structure element height (hs) of the structure element.

4. Magazine cover according to claim 2 or 3, in which the at least one structure element is a bond wire (8).

5. Magazine cover according to any one of the preceding claims, the wall of which is constructed for enlarging the recess (9) depending on the respective forms of a lead frame (2) to be inserted.

6. Magazine cover according to any one of the preceding claims, in which the recess (9) is bounded in lateral direction transversely to the closing direction (6) by at least one wall section (11), which protrudes in closing direction, of the magazine cover (4).

7. Magazine cover of a lead-frame magazine according to claim 6, in which the wall section (11) in closing direction (6) is arranged opposite a region of the lead frame (2) receivable in the lead-frame magazine (1), wherein no structure elements, or no structure elements able to be damaged by impact with the magazine cover (4), are formed on a surface of the lead frame (2).

8. Magazine cover of a lead-frame magazine according to any one of the preceding claims, which is produced by means of an injection-moulding method.

9. Lead-frame magazine with a magazine cover (2) of a lead-frame magazine according any one of the preceding claims.

## Revendications

1. Couvercle de magasin pour magasin de grilles de connexion pour la fermeture d'une ouverture d'un magasin de grilles de connexion par coulissement du couvercle de magasin (4) dans le magasin (1) de grilles de connexion dans une direction de fermeture (6) **caractérisé en ce qu'**il présente un évidement (9) dans la zone d'une arête frontale (10) du couvercle de magasin (4) dans la direction de fermeture (6).

2. Couvercle de magasin pour magasin de grilles de connexion selon la revendication 1 dans lequel l'évidement (9) dans la direction de fermeture (6) est formé dans la zone d'un élément de structure endommageable par le couvercle de magasin (4) s'étendant à la surface et en face d'une grille de connexion (2) préhensible dans le magasin (1) de grilles de connexion.

3. Couvercle de magasin selon la revendication 2 dans lequel une hauteur (h) d'évidement de l'évidement à partir de l'arête frontale (10) est supérieure à une hauteur (hs) d'élément de structure de l'élément de structure.

4. Couvercle de magasin selon la revendication 2 ou 3 dans lequel l'au moins un élément de structure est un fil de liaison (8).

5. Couvercle de magasin selon l'une des revendications précédentes dans lequel sa paroi est conformée de façon à agrandir l'évidement (9) selon la forme d'une grille de connexion à poser.

6. Couvercle de magasin selon l'une des revendications précédentes dans lequel l'évidement (9) est limité sur les côtés et transversalement à la direction de fermeture (6) par au moins un élément de paroi (11) du couvercle de magasin (4) placé dans la direction de fermeture.

7. Couvercle de magasin pour magasin de grilles de connexion selon la revendication 6 dans lequel l'élément de paroi (11) dans la direction de fermeture (6) est situé dans une zone opposée à la grille de connexion (2) préhensible dans le magasin (1) de grilles de connexion et dans laquelle aucun élément de structure endommageable par choc frontal avec le couvercle de magasin (4) n'est fermé sur une surface de la grille de connexion (2).

8. Couvercle de magasin pour magasin de grilles de connexion selon l'une des revendications précédentes fabriqué par un procédé de moulage par injection.

9. Magasin de grilles de connexion avec un couvercle (2) de magasin pour magasin de grilles de connexion selon l'une des revendications précédentes.
